# EUROPEAN PATENT APPLICATION

(11) **EP 0 552 910 A1**
(43) Date of publication of application: **28.07.1993**
(21) Application number: 93300313.9
(22) Date of filing: 19.01.1993
(51) Int. Cl.: H05K 7/10, H01R 23/68, D21H 17/43, D21H 17/37

(54) **Socket**

(30) Priority: 23.01.1992 JP 34239/92
(71) Applicant: TEXAS INSTRUMENTS INCORPORATED, Dallas Texas 75265 (US)
(72) Inventor: Ikeya, Kiyokazu, Shizuoka-Ken 7410-13 (JP); Toyama, Masao, Shizuoka, 140-13 (JP)
(74) Representative: Abbott, David John

(57) **Abstract**

A socket having a base member 1 and a contact element 2 for use in the test of an electrical part 4 on a carrier member 3 which is characterized in that a guide part 2h is provided for directing the movement of the contact element 2 during connection with a lead terminal 4b of the electrical part 4 during the mounting of the electrical part 4 in socket to ensure reliable contacting without damage to the contact element 2 or lead terminal 4b and with minimal noise in operation.

## Description

### Background of the Invention

This invention relates to a socket having a contact element which in connection with the insertion and installation of an IC package (electrical part and semiconducting integrated circuit which will hereinafter be referred to as an IC package), is elastically compressed to provide electrical contact with the electrical part.

In recent years, the IC package has become thin and small, thereby making it more suitable for surface mounting. As the IC package becomes thinner and smaller, the quality of the product becomes more subject to defects with a consequence that testing of the product becomes more important.

In testing of the IC packages including those for surface mounting as described above, the determination of whether an IC package is satisfactory or unsatisfactory is carried out by adding an electrical signal to the IC package.

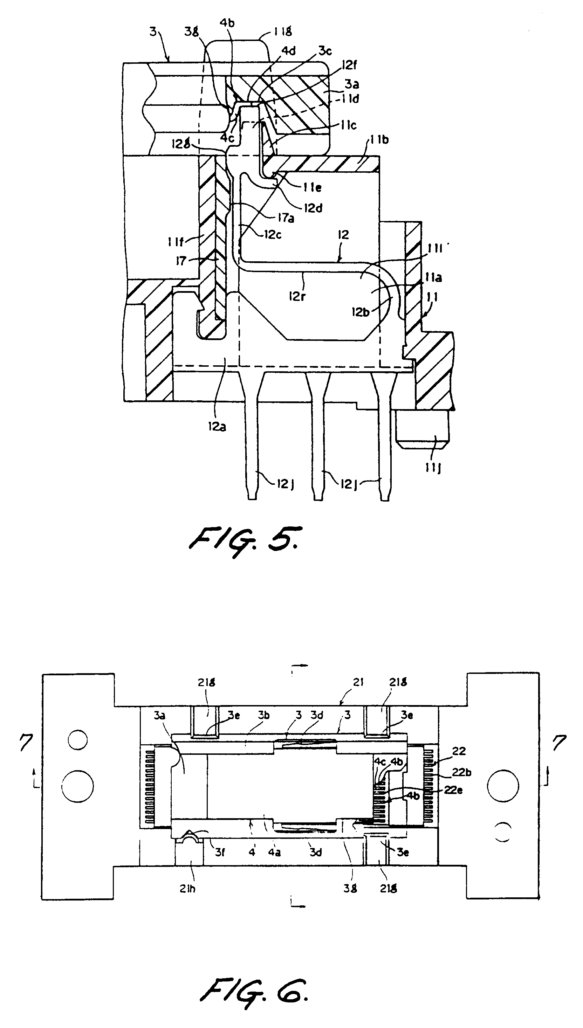

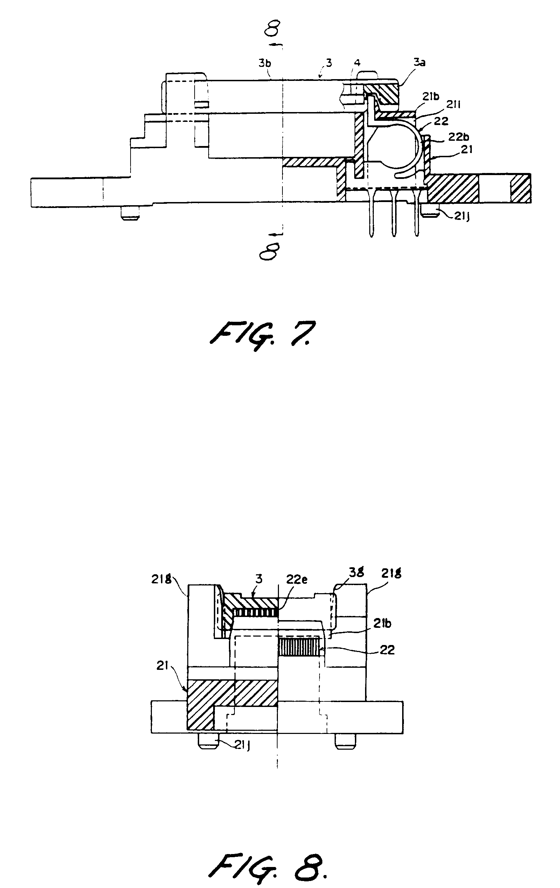

A prior art socket for mounting an IC package to be used in such a test is shown in Figures 6-8. Figure 6 is an expanded plane figure of a socket with an IC package being mounted thereon; Figure 7 is a semi-cross section cut along line 7-7 in Figure 6; and Figure 8 is a semi-cross section cut along line 8-8 in Figure 7.

The socket has a main body 21 and a contact element 22 which has been incorporated into the body 21 plus a carrier 3. The IC package 4 is installed on the reverse side of the carrier 3 and mounted inside the socket.

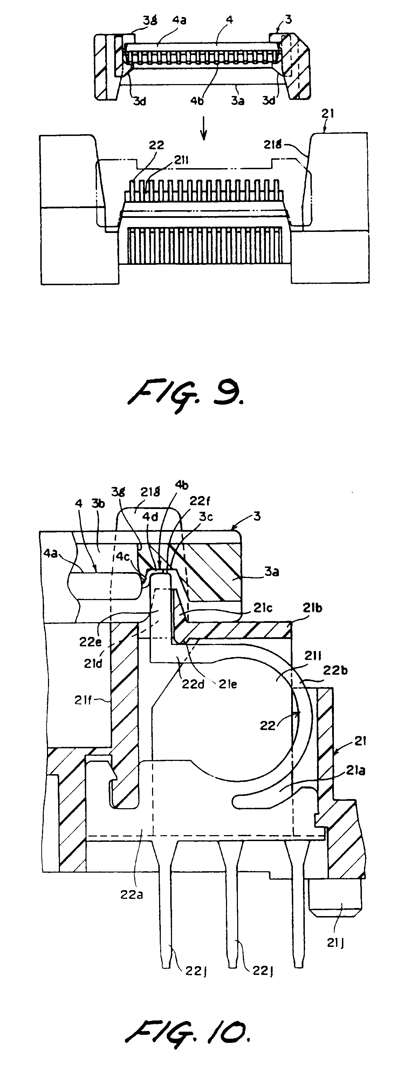

Carrier 3 has mutually opposing concave parts or recesses positioned on the inside (Figure 6) of side wall 3b which contains holding pieces 3d for holding an IC package 4. Three guides 21g and one 21h are provided erect on the body 21 and three concave parts 3e and one 3f are made to fit the guides 21g and 21h respectively with the result that the body 21 and the carrier 3 are mutually positioned. Figure 9 is an expanded cross section showing carrier 3 which holds the IC package 4 by the holder parts 3d and the body 21 prior to insertion of the carrier into the body and then in phantom lines when the carrier 3 is mounted in the body 21 and the socket is assembled as shown in Figures 6-8.

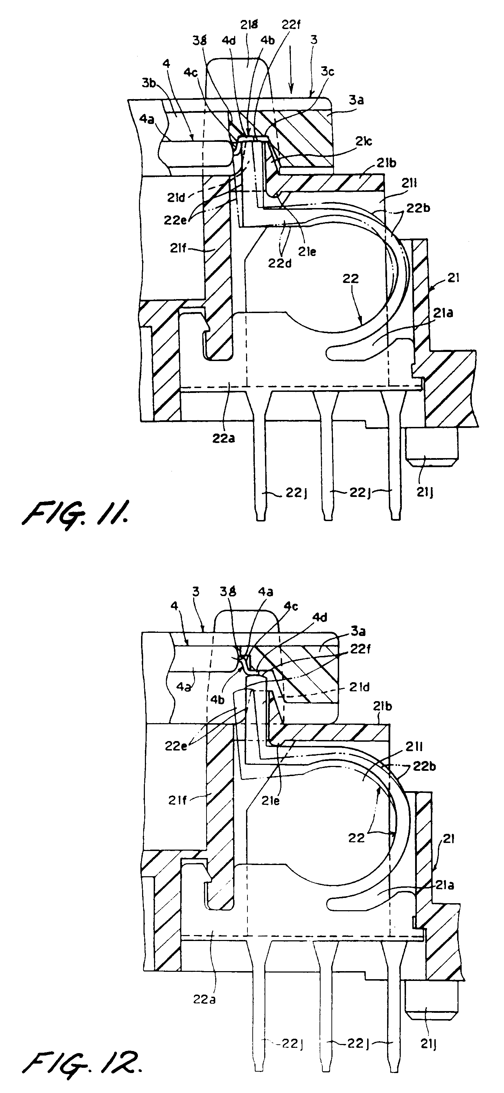

IC package 4 has a large number of leads or contact terminal parts 4b that stick out of mutually facing sides of the main body 4a. Lead 4b comprises a perpendicular part 4c which is bent approximately in a direction which is perpendicular to the main surface of the main body 4a and a tip contact part 4d which is bent from the perpendicular part 4c in a direction which is generally parallel to the main surface of the main body 4a (see Figure 10 which will be discussed later).

Such an IC package is called a TSOP (Thin Small Outline Package), and it is representative of the so-called surface mounting type for installation in parallel with the main surface of the substrate.

As shown in Figure 10, contact 22 is formed by extrusion or etching of a thin sheet of beryllium copper or the like. A curved part 22b extends upward from a base part 22a, with a contact part 22d extending upward toward the upper wall of the body and a contact piece 22e for connection to the lead of the IC package being connected from the curved part 22b.

At the other end of the contact, pins 22j for connection with a testing instrument (not shown) are provided from the base part 22a. The socket is provided with at least the same number of contacts as the member of the leads of the IC package and are arranged with a spacing to coincide with those of the leads in a direction which is vertical to the sheet of Figure 10.

The contact 22 has its base part 22a inserted into a space 21a of the base and is installed on the body 21. The contact 22 has its contact piece 22e biased upward by the spring property of the curved part 22b and, as the contact part 22d of the contact contacts the protrusions 21e which has been provided on the upper wall 21b of the body, the contact piece 22e is positioned.

A concave part 3c or recess is formed on the inside or reverse side of the carrier 3, with the lead 4b of the IC package and the contact piece 22e of the contact being accommodated in the recess part 3c. The sloped side of the IC package 4a contacts a sloped outside surface of recess part 3c, with the result that the IC package 4 is positioned in the width-wise direction as shown in Figure 10. Inside the part 3c, the contact part 4d at the tip of the lead of the IC package is placed on the contact surface 22f at the tip of the contact piece 22e of the contact.

Figure 11 shows the positioning of the IC package inside of the socket at the time of a test. A leg part 21j extends from the bottom of the bottom wall of the body 21 for insertion into a hole in a stand (not shown) for positioning the socket relative to the stand. By a compressive means which is not shown in the drawings, the carrier 3 moves down and the contact piece 22e of the contact also comes down. This movement of contact piece 22e causes the curved part 22b of the contact to become elastically deformed.

The curved part 22b of the contact is elastically deformed and contact piece 22e compressively contacts the contact part 4d at the tip of the lead on the contact surface 22f thereof, with the result that the lead 4 and the pin 22j are electrically connected through the contact 22. Further, as shown in Figures 10 and 11, a guide wall 21d in the shape of comb teeth is provided on an upwardly protruding wall 21c that extends from upper wall 21b of the body, and a guide wall 21i also in the shape of comb teeth is provided in such a way as to extend downward from the upper wall 21b, both of which are positioned between the contacts 22, thereby preventing the contact 22 from contacting the neighboring contacts and, at the same time, guiding the contact surface 22f of the contact piece in such a way as to contact the lead part 4d.

Also, as the curved part 22b becomes elastically deformed, a force causes the contact to be deformed to such a shape as is indicated by an imaginary line in Figure 11, thereby deforming the lead 4b of the IC package in some cases. In addition, the contact 22 of these prior art sockets generates inductance in the semi-circular curved part 22b because of its shape which is similar to a coil with the result that there are potential noise problems such as cross-talk or signal delay, etc.

Still further, even though the vertical part 4c of the lead 4b of the IC package is shown facing upward (Figure 10), there are applications where the lead vertical part 4c is provided facing down as shown in Figure 12. With this configuration as the carrier 3 is mounted, the contact 22 is deformed as shown by an imaginary line, with the result that the contact surface 22f of the contact piece can be easily damaged from the contact part 4d at the tip of the lead. Even if no disengagement occurs, the lead 4b tends to be deformed or the contact piece 22e engages the base, both of which can bring damage to these items.

### Summary of the Invention

Accordingly, it is an object of this invention to provide a socket of high reliability while minimizing the possibility of generating interference noise and damaging the contact or the lead of an IC.

This invention provides for a socket having a main socket body, a contact element having an elastically deformable part adapted to be electrically connected to the connective terminal part of an electrical part upon mounting of the electrical part in the socket, and a guide means which during mounting of the electrical part, regulates the direction of the movement of the contact element.

More specifically, the socket, according to the present invention, has a main body and a resilient contact member for connection to the lead of an IC package. The contact member has a base portion with a spring biased curved portion extending from one side of the base portion which in turn has an upstanding first vertical portion connected to the tip of the curved portion in which the distal end of the vertical portion makes contact with the lead of the IC package. A second upstanding vertical portion extends from the base portion of the contact and guides the movement of the first vertical part during the mounting of the IC package.

Due to the second portion of the contact member guiding the lead contacting first portion of the contact member, no unwarranted forces are applied to the contact member; and contact can be made accurately with the lead assuring desirable and firm connection without damage to the contact or to the lead. Additionally, due to the existence of the first and second upstanding vertical parts, the noise due to the generation of inductance at the curved part is minimal. Still further, the guiding member accurately controls movement of the actual contacting member and provides for wiping of contacting surfaces so that contact resistance is reduced.

### Description of the Drawings

Other objects, advantages and details of the socket of this invention appear in the following detailed description of preferred embodiments of the invention, the detailed description referring to the drawings in which:
Figure 1 is an expanded partial cross-section of the socket of the present invention immediately before the mounting of an IC package in the socket.
Figure 2 is an expanded partial cross-section of the socket of Figure 1 with the IC package mounted;
Figure 3 is an expanded view of an essential part showing the movement of the contact member at the time of movement from the state shown in Figure 1 to the state shown in Figure 2;
Figure 4 is an expanded view of another example similar to Figure 3;
Figure 5 is an expanded partial cross-section of another embodiment of the present invention showing a view similar to Figure 1;
Figure 6 is an expanded plane figure of a conventional prior art socket;
Figure 7 is a partial cross-section cut along line 7-7 in Figure 6;
Figure 8 is a partial cross-section cut along line 8-8 in Figure 7;
Figure 9 is an expanded cross-section cut along line 9-9 in Figure 6, showing the separation between the carrier that holds the IC package and the body;
Figure 10 is an expanded partial cross-section of a conventional socket in a state similar to Figure 1;
Figure 11 is an expanded partial cross-section of the socket of Figure 10 in a state similar to Figure 2; and
Figure 12 is an expanded partial cross-section similar to Figure 10 with the IC package being turned upside down.

### Detailed Description of the Preferred Embodiments

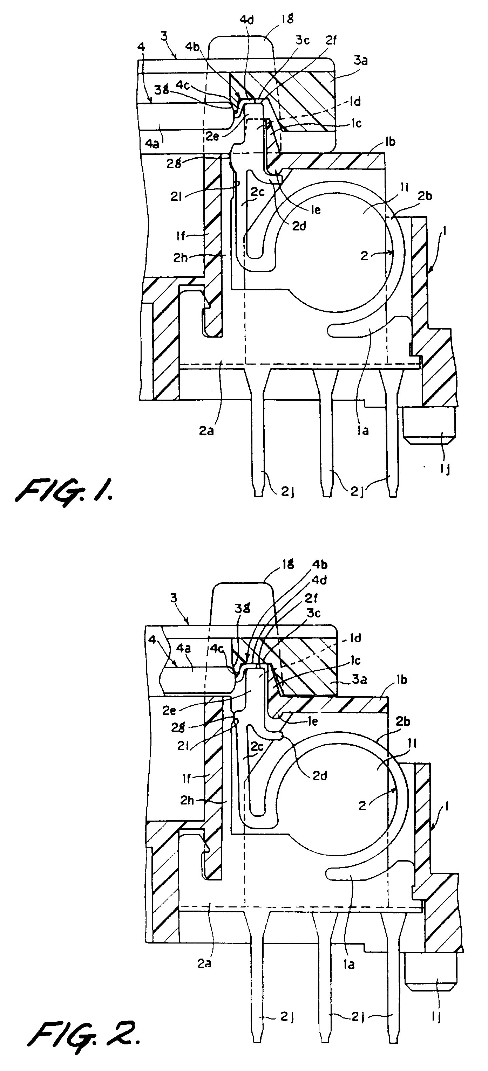

Figure 1 is an expanded partial cross-section of the socket which is in the same state as shown in earlier referred to Figure 10, and Figure 2 is an expanded partial cross-section of the socket which is in a similar state as what is shown in Figure 11. In Figures 10 and 11, those parts which are in common are given the same notation; and the other parts are indicated by using the notation for the parts corresponding to Figures 10 and 11, less twenty.

A contact 2 has the following shape: There is a curved part 2b extending for approximately 270 degrees from a base part 2a, with a first vertical part 2c extending upward from the curved part 2b. First vertical part 2c, as shown in Figure 1, has a contact part 2d and a contact piece 2e extending from it for contacting the upper wall 1b of body 1; and additionally, a first protrusion 2g formed on the opposite side of part 2c from contact part 2d at the joining part between the first vertical part 2c and the contact piece 2e.

A second vertical part 2h extends upward from base 2a, on the second vertical part 2h, a second protrusion 2i is formed immediately below the first protuberant part 2g. Second vertical part 2h is spring biased in a counter clockwise direction, and thus, compressively engages the partition wall 1f forming a partial boundary for empty space 1a of body 1 for its entire length. Thus, the surface boundary on the side of the empty space 1a of partition wall 1f is situated somewhat to the right side of Figure 1, as compared with the surface of the empty space 21a side of partition wall 21f in Figures 10 and 11.

As described earlier in connection with Figure 11, if a carrier 3 is lowered as shown in Figure 2 (in connection with a test), the first vertical part 2c is lowered. At this time, first protrusion part 2g moves down from the location (shown in Figure 1) on the second protrusion 2i of second vertical part 2h, thereby assuming a position of being astride or directly opposite second protrusion part 2i.

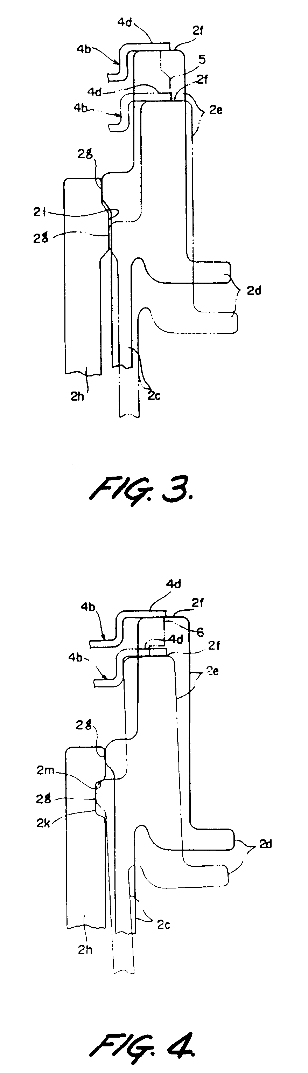

As a result of this movement, the apex of contact piece part 2e moves along the path 5 shown by a single-dot chain line in Figure 3. In Figure 3, the solid line indicates the state shown in Figure 1 and the two-dot chain line indicates the state shown in Figure 2, where first protrusion part 2g is astride over the second protrusion part 2i.

Since the length of the second vertical part 2h of the contact is sufficiently smaller than the length of the curved part 2b, the electrical current that passes through the contact passes between the pin 2j and the lead 4b of the IC package through the second vertical part 2h. Accordingly, the problem of noise stemming from the previously mentioned inductance is so small that it becomes insufficient.

As is also shown in Figure 3, there is a reciprocal movement from the left to the right as first protrusion moves downward on second protrusion 2i. This reciprocating motion causes contact piece 2e to move from left to right across contact part 4d thereby causing contact wiping between the contact surface and the tip of the lead of the IC package.

This contact wiping is important because typically lead 4b is solder plated and an oxide coating forms on the solder plated lead which the wiping tends to remove to improve contact reliability. Additionally, this wiping action can remove any build-up of oxidized solder that may have adhered to contact surface 2f to again minimize contact resistance.

All other parts of the socket, except those set forth above in describing this embodiment, will be the same as explained with regard to Figures 6-11, with even the installation of the IC package, upside down, as shown in Figure 12, being carried out smoothly without any hindrance whatsoever. It is mentioned in this connection that, after the test, carrier 3 is removed from the body 1 by employing an elevator which is equipped with a carrier support mechanism, followed by the pushing of the main body 4a of the IC package 4 through an opening 3g at the center of the carrier 3, thereby disengaging the IC package from the carrier.

An alternate design to that shown in Figure 3 is provided for in Figure 4. In this embodiment, a recess or concave portion 2k is provided in second vertical part 2h in place of the second protrusion 2i. The first vertical part 2c is spring biased toward the second vertical part 2h. Thus, when the first vertical part moves downward, protuberant part 2h moves downward also coming to rest in recess or concave part 2k causing the contact piece 2e to move counter clockwise and provide wiping of the lead. This counter clockwise movement is enhanced by having the upper sloped surface of the concave part 3k being a sharp slope 2m which along with the spring biased force of the first vertical part, causes the apex of the contact piece 2e to move along a path shown by two-dotted chain line in Figure 4 at the time of the lowering of the carrier.

As in the case of the first embodiment, the contact surface 2f of the contact piece 2e provides a wiping action against the contact part 4d at the tip of the lead of the IC package, thereby making the effect of such wiping all the more pronounced. In this example, the contact piece 2e of the contact is made to contact the lead vertical part 4c, separated by the dimension of movement, so as to make it possible to effect the described wiping action.

The second vertical part need not be provided as an integral part of the contact. Second vertical part 2h may be fixed to the partition wall of the base as a separate member. In addition, it is possible to reduce the curvature of the curved part of the contact as compared with previously described curved part 2b.

Figure 5 shows an expanded partial cross-section of such a socket in a design similar to what is shown in Figure 1. Those parts, which are in common with Figure 1, have been given the same rotation, and the other parts have been given notation of those parts corresponding to Figure 1, plus 10.

In this embodiment, the second vertical part (2h in Figure 1) is not provided in the contact but an electroconductive plate 17 in a shape similar to the second vertical part 2h in Figure 1 (with a second protuberant part 17a being provided) has been affixed to a partition wall 11f of body 11. The electroconductive plate 17 can be made from electroconductive resin, resin plated with gold, metal, etc., and resin with the coating of an electroconductive painting material in addition to such metals as copper alloys, etc. In the case of an electroconductive resin, a electroconductive material ingredient and a synthetic resin ingredient are combined together. Examples of electroconductive material ingredients are metal fiber powder, carbon powder, carbon fiber powder, etc. By using this method, the material cost of the contact can be reduced and the dimensional accuracy can be improved.

As shown in Figure 5, the curved part 12b of a contact 12 has its radius of curvature smaller than the curved part 2b in Figure 1, with a horizontal part 12r extending from the tip of curved part 2b with an upward extending vertical part 12c (corresponding to the first vertical part 2c in Figure 1) extending upward from the tip of the horizontal part 12r.

By giving contact 12 this shape, the spring property force of the curved part and contact 12 is larger so as to provide a wiping effect that is more pronounced than provided by the contact 2 of Figure 1.

When the first vertical part 12 is moved downward, the lower end of these vertical parts move slightly in a direction toward the curved part of the contact. Accordingly, the top portions of these vertical parts move in an opposite direction away from the curved part. This means wiping will occur even without providing the second vertical part 2h with protuberant part 2i or electroconductive sheet 17 with protuberant part 17a.

Second vertical part 2h and electroconductive sheet 17 are required to have good wear resistance properties such as teflon or nickel or chromium plated materials. Further, second vertical part 2h, as a result of being integral with the contact, must be able to withstand etching, acid cleaning and shaving.

Accordingly, the socket of the present invention provides for a guide means for regulating the direction of movement of a contact element in the socket in connection with the mounting of electrical parts on the main socket body, so that the contact element moves accurately and precisely to connect to the connective terminal part of the electrical parts.

Further, with this socket no unwarranted force will be added to the contact element; and accurate connection will be made without any damage to either the contact element or the connective terminal, thereby providing for a durable socket that is highly reliable in operation. Still further, due to the existence of the first and second vertical parts and their positioning, the noise due to the generation of inductance at the curved part is minimized, and the protuberant parts on the vertical parts assure for wiping action of the contacts so that the contact surfaces are clean with minimum contact resistance.

This invention has been described above, however, the aforementioned embodiments can be modified in conformity with the technical concept of this invention. For example, the shapes, materials and installation locations of the contact and body can be modified and, in addition, the shape, material, and construction of the carrier may also be modified. It is also possible to use an adaptor so that IC packages of various shapes and dimension may be used. This invention also can, of course, be used with electrical parts other than an IC package.

## Claims

1. A socket for receiving an electrical part with terminal leads comprising a main socket body, a plurality of electrically conductive contact elements received in said socket body having an elastically deformable part and adapted to be electrically connected to said terminal leads of the electrical part during mounting of said electrical part in the socket and a plurality of guide members, each positioned in contact with one of the contact elements for accurately controlling the direction of movement of the contact element during movement of the contact elements relative to the terminal leads.

2. A socket according to claim 1 wherein said plurality of contact elements each has a base portion with a terminal means extending from one side of said base portion out of said socket body, a curved portion extending from an opposite side of the base portion from the terminal means, a first vertical portion extending from the curved portion at the end opposite to the end of the curved portion in contact with the base member, the first vertical portion having at its distal end a contact piece for engagement with one of said terminal leads and a protrusion along its length for engagement with the guide member.

3. A socket according to claim 2 wherein in each case the guide member comprises a second vertical part attached to and extending from said base portion of the contact element to be in engagement with said first vertical portion of the contact element.

4. A socket according to claim 3 wherein in each case the second vertical part has a protrusion directly facing the protrusion on the first vertical portion adapted to engage the first vertical portion protrusion during mounting of the electrical part in the socket to help in guiding movement of the contact when connecting to the terminal lead and to ensure wiping of the contact surface.

5. A socket according to claim 2 wherein said guide members comprise a plurality of second vertical parts mounted in said socket body so that each of said plurality of second vertical parts is in contact with one of said plurality of contact elements so as to control movement of said contact elements.

6. A socket according to claim 5 wherein said plurality of second vertical parts each has a protrusion directly facing said protrusion on each of the first vertical portions and said second vertical part protrusions are adapted to be engaged by the first vertical portion protrusions during mounting of the electrical part in the socket to help in guiding movement of the contacts when connecting to the terminal leads and to ensure wiping of the contact surfaces.

7. A socket according to claim 5 wherein each of said plurality of second vertical parts is shorter in length than said curved portion of said contact elements and is in electrical contact with said first vertical portion and said base portion of said contact elements to minimize any electrical noise when testing said electrical parts.

8. A socket according to claim 5 wherein said plurality of second vertical parts each has a recess directly facing said protrusion on each of the first vertical portions and said recesses are adapted to receive said first vertical portion protrusions during mounting of the electrical part in the socket to help in guiding movement of the contacts when connecting to the terminal lead and to ensure wiping of the contact surfaces.

9. A socket according to claim 1 in which said guide members bias the contact elements in a direction different from the direction from the compression caused by the mounting of the electrical part in the main socket body.
